Europäisches Patentamt

European Patent Office

Office européen des brevets

(19)

(11) veröffentlichungsnummer: **0 016 395**

**A2**

(12) **EUROPÄISCHE PATENTANMELDUNG**

(21) Anmeldenummer: 80101218.8

(22) Anmeldetag: 10.03.80

(51) Int. Cl.³: **G 05 D 3/10**
**G 01 B 3/22, H 04 N 5/22**
**A 61 B 10/00**

(30) Priorität: 14.03.79 DE 2910012

(43) Veröffentlichungstag der Anmeldung:
01.10.80 Patentblatt 80/20

(84) Benannte Vertragsstaaten:
AT CH FR GB NL

(71) Anmelder: SIEMENS AKTIENGESELLSCHAFT Berlin
und München
Postfach 22 02 61
D-8000 München 22(DE)

(72) Erfinder: Hölzer, Georg, Dipl.-Ing.
Kellergasse 18
D-8521 Möhrendorf(DE)

(72) Erfinder: Knoche, Jochem, Dipl.-Ing.
Hansengarten 19
D-8500 Nürnberg(DE)

(54) Mechanisch/elektrische Steuervorrichtung zum Verschieben eines Gegenstandes.

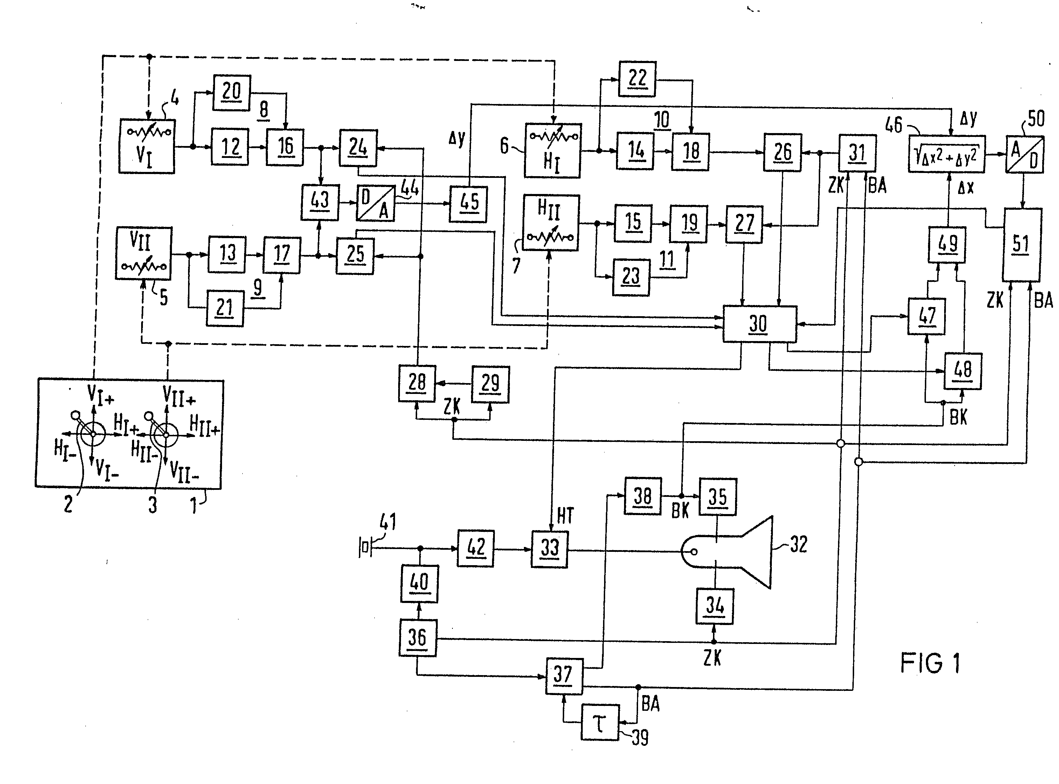

(57) Die Erfindung bezieht sich auf eine mechanisch/elektrische Steuervorrichtung zum Verschieben eines Gegenstandes, insbesondere Markierungen auf dem Bildschirm einer Bildröhre, in eine erwünschte Position, mit wenigstens einem von Hand aus einer Ruhelage auslenkbaren Proportionalgeber, der Auslenksignale entsprechend der Auslenkung erzeugt und mit einem Positionssignalgeber, der gesteuert von den Auslenksignalen des Proportionalgebers Positionssignale zur Verschiebung des Gegenstandes erzeugt. Ziel der Erfindung ist es, eine Steuervorrichtung zu schaffen, bei der die Positionseinstellung am Proportionalgeber ohne Ermüdung der Hand mit besonders guter Genauigkeit und Feinfühligkeit durchführbar ist. Dieses Ziel wird gemäß der Erfindung dadurch erreicht, daß zwischen Proportionalgeber (1 bis 7) und Positionssignalgeber (24 bis 31) eine Festhaltevorrichtung (16 bis 23) zum Festhalten jeweils jenes Auslenksignales einer Auslenkung des Proportionalgebers (1 bis 7) vorhanden ist, das im Umkehrpunkt der Auslenkung vor Rührung des Proportionalgebers in die Ruhelage anfällt (Fig. 1).

./...

FIG 1

SIEMENS AKTIENGESELLSCHAFT     Unser Zeichen
Berlin und München          VPA 79 P 5016 EUR

**Mechanisch/elektrische Steuervorrichtung zum Verschieben eines Gegenstandes**

Die Erfindung bezieht sich auf eine mechanisch/elektrische Steuervorrichtung zum Verschieben eines Gegenstandes, insbesondere Markierungen auf dem Bildschirm einer Bildröhre, in eine erwünschte Position, mit wenigstens einem von Hand aus einer Ruhelage auslenkbaren Proportionalgeber, der Auslenksignale entsprechend der Auslenkung erzeugt und mit einem Positionssignalgeber, der gesteuert von den Auslenksignalen des Proportionalgebers Positionssignale zur Verschiebung des Gegenstandes erzeugt.

Steuervorrichtungen der genannten Art sind vielseitig anwendbar. So findet sich unter anderem ein Einsatz in der Modellbautechnik zur Steuerung des Ruders von Modellschiffen oder Modellflugzeugen. Sie können ebensogut zur Fernsteuerung von Richtantennen eingesetzt werden. Ein weiteres mögliches Einsatzgebiet ist das Setzen

Kue 5 Kof / 2.3.1979

- 2 -     VPA 79 P 5016 EUR

von Markierungen auf dem Bildschirm einer Bildröhre, insbesondere von Abstandsmarken zur Ermittlung des Abstandes zwischen zwei Punkten eines Sichtbildes. Durch die DE-OS 27 19 118 ist beispielsweise eine derartige Steuervorrichtung für Ultraschall-Schnittbildgeräte vorbekannt. Besondere Eigenschaft der bekannten Steuervorrichtungen ist, daß die Positionssignale zur Verschiebung des Gegenstandes, die vom Proportionalgeber erzeugt werden, unmittelbar proportional sind zu den Auslenksignalen des Proportionalgebers. Damit ist also der Verschiebeweg des Gegenstandes direkt proportional zum Auslenkweg des Proportionalgebers. Eine bestimmte Endposition des Gegenstandes kann also nur beibehalten werden, wenn auch am Proportionalgeber der entsprechende Auslenkweg beibehalten wird. Eine solche Arbeitsweise ist umständlich und wirkt sich auch auf die Hand der Bedienungsperson ermüdend aus, was dazu führt, daß Positionseinstellungen nicht mehr mit der erwünschten Genauigkeit und Feinfühligkeit durchgeführt werden können.

Aufgabe vorliegender Erfindung ist es, eine Steuervorrichtung zu schaffen, die sich besser als bisher handhaben läßt.

Die Aufgabe wird erfindungsgemäß dadurch gelöst, daß zwischen Proportionalgeber und Positionssignalgeber eine Festhaltevorrichtung zum Festhalten jeweils jenes Auslenksignals einer Auslenkung des Proportionalgebers vorhanden ist, das im Umkehrpunkt der Auslenkung vor Rückführung des Proportionalgebers in die Ruhelage anfällt.

Die Erfindung ermöglicht die Festhaltung des zu verschiebenden Gegenstandes in einer erwünschten Endposition der Verschiebung, ohne daß gleichzeitig der Proportionalgeber von Hand in der zugeordneten Endposition gehalten werden muß. Im Gegensatz zu bisher kann also nach Einstellen einer Endposition der Proportionalgeber in die Ruhelage zurückgebracht werden. Dies entlastet die Hand der Bedienungsperson. Korrekturen der Endposition bzw. Einstellung neuer Positionen können in einfachster Weise dadurch erfolgen, daß aus der Ruhelage hinaus in einer entgegengesetzten Richtung am Positionsgeber die neue Position oder die korrigierte Position eingestellt wird. Da die Hand der Bedienungsperson kaum belastet wird, ergibt sich erhöhte Sicherheit bei der Feineinstellung.

Diese Sicherheit der Feineinstellung wird noch um ein Vielfaches erhöht, wenn in vorteilhafter Ausgestaltung der Erfindung die Festhaltevorrichtung als Teil eines zwischen Proportionalgeber und Positionssignalgeber eingeschalteten Auslenkweg/Verschiebungsgeschwindigkeit-Umsetzers ausgebildet ist, der ein mit zunehmendem Auslenkweg des Proportionalgebers sich entsprechend rascher änderndes Auslenksignal zur entsprechend rascheren Aktivierung des Positionssignalgebers im Sinne der schnelleren Verschiebung des Gegenstandes erzeugt. Bei einer derartigen Ausgestaltung der Erfindung bestimmt die Auslenkung des Proportionalgebers also nicht mehr direkt den Auslenkweg; festgelegt wird in Abhängigkeit von der Auslenkung des Proportionalgebers nur noch die Richtung und die Geschwindigkeit der Verschiebung. Der zu verschiebende Gegenstand kann also durch starke Auslenkung des Proportionalgebers zu Beginn der Verschiebung rasch in Richtung auf die gewünschte Endposition gebracht werden. Durch Rücknahme der Auslenkung verringert sich die Verschiebungsgeschwindigkeit und der Gegenstand kann in besonders feinen Schritten in die

- 4 -    VPA 79 P 5016 EUR

Endposition eingefahren werden. Dort verbleibt er bei Rücknahme des Proportionalgebers in die Ruhelage so lange, bis durch letzteren ein neues Verschiebungssignal gegeben wird.

Weitere Vorteile und Einzelheiten der Erfindung ergeben sich aus der nachfolgenden Beschreibung eines Ausführungsbeispiels anhand der Zeichnung in Verbindung mit den Unteransprüchen.

Es zeigen:

Fig. 1 das Prinzipschaltbild einer Steuervorrichtung gemäß der Erfindung zur Verschiebung von Meßkreuzen als Abstandsmarkierungen auf dem Bildschirm der Bildröhre eines Ultraschall-Schnittbildgerätes,

Fig. 2 eine Steuerlogik für Markeneinblendung des Prinzipschaltbildes der Fig. 1 in aufgegliederter Darstellung,

Fig. 3 das Ausführungsbeispiel der Einblendung zweier Meßkreuze in die Zeilenablenkung einer Bildröhre, insbesondere jener des Prinzipschaltbildes der Fig. 1.

In der Fig. 1 befinden sich an einem Bedienpult 1 zwei von Hand zu bewegende Steuerknüppel 2 und 3. Die Steuerknüppel 2 und 3 sind mit geringem Kraftaufwand in den Vertikalen $V_I$ und $V_{II}$ bzw. in den Horizontalen $H_I$ und $H_{II}$ bewegbar. Auslenkungen in anderen Richtungen sind nur mit erhöhtem Kraftaufwand möglich. Die jeweils eine der horizontalen oder vertikalen Richtungen ist mit + und die dazu entgegengesetzte mit - gekennzeichnet. Der Kreuzpunkt legt die Ruhelage des Steuerknüppels fest. Jeder Steuerknüppel wird durch ein Federsystem in der Ruhelage gehalten. Eine Auslenkung erfolgt gegen den Zug des Federsystems. Wird der Steuerknüppel losgelassen, so geht er aufgrund des Federzugs automatisch in die Ruhelage zurück. Jeder Steuerknüppel 2 und 3 ist kraftschlüssig mit dem Schleifkontakt je eines Widerstandspotentiometers 4, 5 für die Vertikalauslenkung und je eines Widerstandspotentiometers 6, 7 für die Horizontalauslenkung des Steuerknüppels verbunden. In der Ruhelage der Steuerknüppel befindet sich der Schleifer jedes Potentiometers in Mitte der Widerstandsbahn. Die Widerstandsbahn eines jeden Potentiometers ist auf der einen Seite mit einer positiven Spannung +U und auf der anderen Seite mit einer entgegengesetzten Spannung -U derselben Größe beschaltet. In Mittenlage aller Schleifer ergibt sich also für sämtliche Potentiometer die Ausgangsspannung Null. Es findet keine Verschiebung eines Meßkreuzes statt. Auslenkungen des jeweiligen Steuerknüppels 2 oder 3 in positiver Vertikal- oder Horizontalrichtung bewirken hingegen eine Verschiebung des Schleifers aus der Mittenlage in Richtung positiver Spannung am jeweiligen Potentiometer mit entsprechender Richtungsverschiebung des Meßkreuzes am Bildschirm. Dasselbe gilt für Auslenkung in negativer Vertikal- bzw. Horizontalrichtung mit Auslenkung des Schleifkontaktes aus der Mittenlage in Richtung negativer Spannung.

Die Steuerknüppel 2 und 3 bilden demnach in Verbindung mit den Potentiometern 4 bis 7 einen Proportionalgeber, der an seinem Ausgang (Schleifkontakte der Potentiometer) eine Ablenkspannung erzeugt, die nach Vorzeichen und Amplitude proportional ist der Auslenkung des Steuerknüppels in der zugehörigen Koordinatenrichtung. Diese Auslenkspannung erzeugt gemäß besonderer Ausbildung der weiterverarbeitenden Schaltungsteile allerdings nicht gleichzeitig Proportionalität hinsichtlich der Auslenkstrecken von Meßknüppel und Meßkreuz. Die Weiterverarbeitung erfolgt vielmehr in dem Sinne, daß die Auslenkamplitude des Meßknüppels mittels Auslenkweg/Verschiebungsgeschwindigkeit-Umsetzers in eine proportionale Verschiebungsgeschwindigkeit umgesetzt wird. Weite Knüppelauslenkung bewirkt also sehr rasche Ablenkung des Meßkreuzes in der entsprechenden Koordinatenrichtung über dem Bildschirm. Eine nur geringfügige Auslenkung führt hingegen zu sehr langsamer Verschiebungsgeschwindigkeit. Zur Durchführung dieser Maßnahmen umfaßt der Auslenk/Verschiebungsgeschwindigkeit-Umsetzer für jedes zu verarbeitende Koordinatensignal eines Steuerknüppels mit zugeordnetem Potentiometer eine spezielle Umsetzschaltung 8, 9, 10 bzw. 11. Jede dieser Umsetzschaltungen besteht dabei im Prinzip aus einem spannungsgesteuerten Impulsoszillator 12, 13, 14, 15, dessen Ausgangs-Impulsfolgefrequenz sich mit zunehmender Ausgangsspannung des vorgeschalteten Potentiometers entsprechend erhöht. Die von den Impulsoszillatoren erzeugten Impulse werden entsprechend der Folgefrequenz in nachgeschaltete Vor-Rück-Zähler 16, 17, 18 bzw. 19 eingezählt. Eine Umschaltung von Vorwärts- auf Rückwärtszählung und umgekehrt erfolgt durch das Ausgangssignal eines Richtungssignalgebers 20, 21, 22 und 23, der in Abhängigkeit von der Polarität des Ausgangssignals eines jeden Potentiometers 4 bis 7 ein entsprechendes Richtungsumschaltsignal erzeugt.

Im Ausführungsbeispiel der Fig. 1 legen die Umsetzschaltungen 8 und 9 immer die Geschwindigkeit der Verschiebung einer Meßmarke in Vertikalrichtung des Bildschirms einer Bildröhre fest. Die Vertikalrichtung ist

- 7 -    VPA 79 P 5016 EUR

im vorliegenden Falle gleichzeitig die Auslenkrichtung einer Zeile. Der Pulsoszillator 12 bzw. 13 ist speziell in einem Frequenzbereich von 0 bis 50 kHz variabel. Die Zählkapazität des Vor- und Rückzählers 16 bzw. 17 beträgt ca. maximal 12 bit. Beides zusammen ergibt eine Auflösung von 4.096 Schritten pro Ablenkzeile. Im Falle der Horizontalablenkung ist die Auflösung der Verschiebungsschritte durch die Gesamtzeilenzahl des Bildschirms auf z.B. 256 begrenzt. Diese geringzahligere Schrittauflösung erlaubt den Einsatz von Pulsoszillatoren 14, 15 mit geringerer Frequenzschwankungsbreite. Auch die Vor- und Rück-Zähler 18, 19 kommen mit einer kleineren Zählkapazität aus. Im vorliegenden Ausführungsbeispiel liegt beispielsweise der Frequenzbereich jedes Pulsoszillators 14 bzw. 15 zwischen 0 bis etwa 10 kHz, während die Zählkapazität der Zähler 18 und 19 im Bereich 8 bit liegt.

Mit den bisher geschilderten Schaltungsmaßnahmen ergibt sich somit eine Verschiebung einer Meßmarke auf dem Bildschirm einer Bildröhre in einfachster Weise wie folgt:

Die Endposition einer Meßmarke wird festgelegt durch eine Summe aus Einzelschrittsignalen bei schrittweiser vertikaler und horizontaler Verschiebung. Die Verschiebungsgeschwindigkeit soll anfänglich groß sein, damit die Meßmarke sehr rasch in den Bereich ihrer späteren Endposition gebracht wird. Durch Verringerung der Knüppelauslenkung und damit Rücknahme der Verschiebungsgeschwindigkeit für das Meßkreuz erfolgt dann Eintastung in die Endposition in feinen Schritten. Zur Plazierung der Meßmarke in einem bestimmten Quadranten wird also der Steuerknüppel zuerst in einer der beiden Koordinatenrichtungen dieses Quadranten weit ausgelenkt. Das entsprechend zugeordnete Widerstandspotentiometer erzeugt eine große Ausgangsspannung, die die Frequenz des Pulsoszillators zu hohen Werten verschiebt. Der nachgeschaltete Zähler wird entsprechend schnell hochgezählt und die Meßmarke wird in Abhängigkeit vom Ausgangssignal dieses Zählers in der eingenommenen Koordinatenrichtung sehr rasch verschoben. Dann erfolgt Feinregulierung im obigen Sinne. Ist der Endpositionswert der Koordinatenrichtung erreicht, so wird der Steuerknüppel in die Ruhelage zurückgebracht. Die Frequenz des jeweiligen Pulsoszillators geht auf Null zurück. Es werden keine weiteren Impulse mehr ausgezählt und der vorher erreichte höchste Zählstand des Vor-Rück-Zählers wird als Speicherwert zur Festhaltung der Koordinatenposition festgehalten. Anschließend erfolgt dieselbe Maßnahme durch Auslenkung des Steuerknüppels in der anderen Koordinatenrichtung. Der Endstand dieser Koordinatenposition wird dann durch den dafür zugeordneten Vor-Rück-Zähler festgehalten. Damit befindet sich also die Meßmarke am Ort der Endposition.

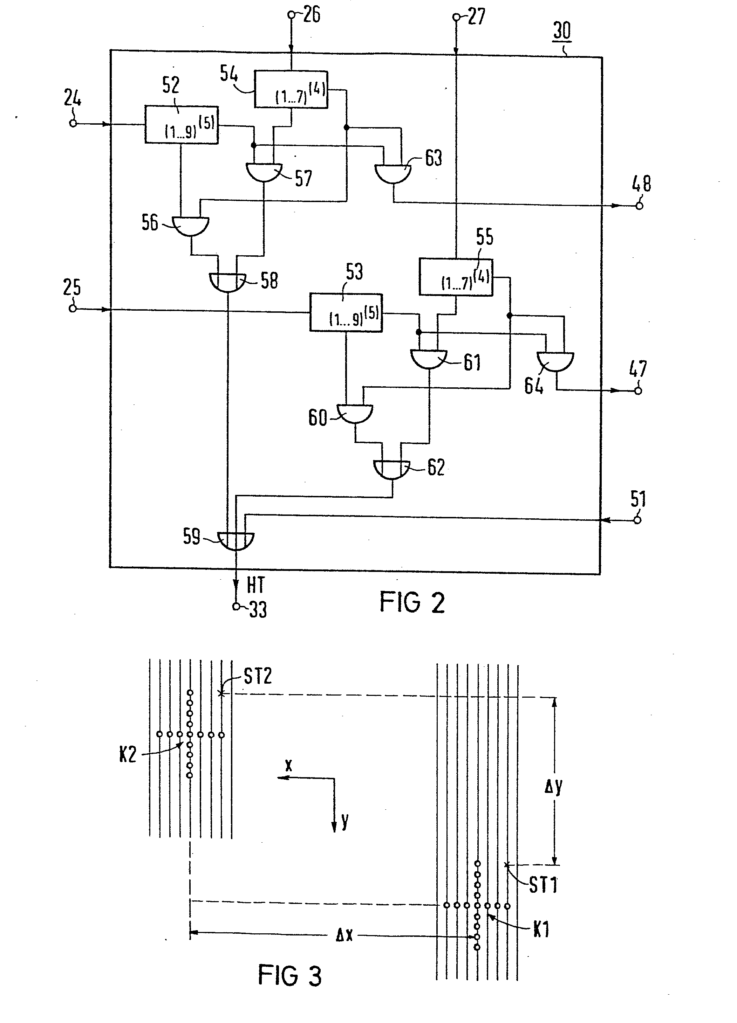

Die Meßmarke selbst kann beliebige Form aufweisen. Sie kann also sowohl punkt- als auch z.B. kreisförmig oder sonstwie gestaltet sein. In bevorzugter Ausbildung dienen im vorliegenden Fall Kreuze als Markierungsmarken. Gemäß der Fig. 3 besteht dabei jedes Meßkreuz in der Vertikalen (z.B. Zeilenrichtung) aus neun Hellpunkten. In der Horizontalen (Zeilenverschieberichtung) umfaßt das Meßkreuz nur sieben Hellpunkte. Die Punktzahl hat jedoch lediglich exemplarischen Charakter; selbstverständlich kann jedes Meßkreuz auch aus einer anderen Anzahl von Punkten aufgebaut sein.

Zur jeweils richtigen Plazierung der Hellpunkte eines jeden Kreuzes auf dem Bildschirm der Bildröhre müssen die durch die Vor-Rück-Zähler 16, 17, 18 bzw. 19 jeweils vorgegebenen Koordinatensignale in vertikaler Richtung mit der Ablenkgeschwindigkeit der jeweils zugeordneten Zeile am Röhrenbildschirm und in horizontaler Richtung mit der Zeilenverschiebegeschwindigkeit synchronisiert werden. Im vorliegenden Ausführungsbeispiel geschieht dies unter Zuhilfenahme von Komparatoren 24, 25, 26 und 27. Die Komparatoren 24 und 25 vergleichen dabei den Zählerstand der Zähler 16 und 17 mit dem Zählerstand eines Zählers 28, der im Takt ZK der Zeilenauslenkung jeweils aus der Ruhelage angestoßen wird und während der Zeitdauer der Zeilenauslenkung mit Impulsen eines gleichzeitig angeworfenen Taktgenerators 29 (quarzstabilisierter 14 MHz-Impulsgenerator) gespeist wird. Bei Gleichstand der Zählerausgänge wird von jedem Komparator 24, 25 ein Ausgangssignal auf eine Steuerlogik 30 zur Markeneinblendung auf den Bildschirm einer Bildröhre gegeben. Entsprechend der Vertikalsynchronisation entlang einer Zeile ergibt sich Horizontalsynchronisation in aufeinanderfolgenden Zeilen durch die Komparatoren 26 und 27. Beide Komparatoren vergleichen den Zählerstand der Vor-Rück-Zähler 18 und 19 mit dem Zählerstand eines Zeilenzählers 31, der jeweils mit dem Bildanfangssignal BA aus der Ruhelage angestoßen und im Takt der Zeilenauslöseimpulse ZK hochgezählt wird. Bei Gleichstand der Zählerstände wird vom Komparator 26 bzw. 27 wieder ein Ausgangssignal für die Steuerlogik 30 erzeugt. Aufgrund der jeweils eingespeisten Komparatorausgangssignale erzeugt diese Steuerlogik 30 über eine Ausgangsleitung Helltastimpulse HT für die Bildröhre.

In der Fig. 1 ist die Bildröhre mit 32 bezeichnet und die Helltasteinrichtung trägt die Kennziffer 33. Der Zeilenkippgenerator der Röhre 32 ist mit 34 und der Bildkippgenerator mit 35 bezeichnet. Die Steuerung der beiden Kippgeneratoren erfolgt durch einen zentralen Taktgenerator 36, der an einem ersten Ausgang die Zeilenkippimpulse ZK erzeugt. Über einen zweiten Ausgang werden die Impulse des zentralen Taktgenerators 36 auf einen Zähler 37 gegeben, der einerseits über einen Digital-Analog-Wandler 38 die Bildkippimpulse BK erzeugt; andererseits erzeugt er in Verbindung mit dem Verzögerungsglied 39 die Bildanfangsimpulse BA. Da es sich bei vorliegendem Ausführungsbeispiel der Fig. 1 um ein Ultraschall-Schnittbildgerät handelt, werden die Ausgangsimpulse des zentralen Taktgebers 36 über einen dritten Ausgang auch noch auf einen Hochfrequenzimpulsgeber 40 gegeben. Dieser Hochfrequenzimpulsgeber 40 erzeugt im Takt der Impulse des zentralen Taktgebers Hochfrequenzerregungsimpulse für einen Ultraschallwandler 41. Die aufgrund der Sendeimpulse des Ultraschallwandlers 41 aus einem Untersuchungsobjekt anfallenden Echoimpulse werden über einen Empfangsverstärker 42 in bekannter Weise auf die Einrichtung 33 der Bildröhre 32 zur Helligkeitsmodulation der Bildzeilen in Abhängigkeit von den anfallenden Echosignalen gegeben. Der Ultraschallwandler 41 ist in der Fig. 1 nur schematisch dargestellt. Es kann sich hierbei um einen verschiebbaren Einzelschwinger (Compound-Scan) handeln. Ebensogut ist die Ausbildung als Ultraschall-Array mit einer Vielzahl nebeneinander angeordneter Ultraschallschwinger oder als sich drehender Rotationsschwinger mit z.B. Parabelreflektor möglich.

Bei vorliegendem Ausführungsbeispiel wirft die Positionierung und Erzeugung der Meßkreuze ein wichtiges Problem auf. Gemäß der Anwendung soll jeweils der Schnittpunkt der beiden Kreuzbalken einen Meßpunkt im Sichtbild der Bildröhre 32 festlegen, dessen Abstand zu einem anderen Meßpunkt bestimmt werden soll, der wiederum durch den Kreuzpunkt zweier Balken eines weiteren Meßkreuzes festgelegt ist. In der Bildaufzeichnung der Kreuze gehen nun jedem Mittelpunkt eines Meßkreuzes in Horizontalrichtung, d.h. in Zeilenverschieberichtung, Helltastpunkte des horizontalen Kreuzbalkens und in Vertikalrichtung (Zeilenrichtung) Hellpunkte des vertikalen Kreuzastes voraus. Damit nun diese Punkte als wesentlicher Bestandteil des Markierungskreuzes vor Erreichung des eigentlichen Kreuzmittelpunktes aufgezeichnet werden, muß man sich in der Schaltung gemäß der Fig. 1 bis 3 eines besonderen Tricks bedienen. Dieser Trick besteht darin, daß, wie es in der Fig. 3 näher dargestellt ist, für jedes Markierungskreuz K1 bzw. K2 schaltungsintern bereits vor Erreichung des eigentlichen Kreuzmittelpunktes ein Startzeitpunkt für den Aufzeichnungsvorgang markiert wird. In der Fig. 3, in der beispielsweise die Zeilenablenkung von oben nach unten in y-Richtung und der Bildaufbau durch Verschiebung der Zeile von rechts nach links in x-Richtung erfolgen sollen, sind die Startzeitpunkte der Kreuze K1 und K2 jeweils mit ST1 und ST2 bezeichnet. Gemäß dem vorliegend angewandten Trick werden demnach bereits die Koordinatensignale dieser Startpunkte ST1 und ST2 durch Gleichheit der Signale an den Komparatoren 24 bis 27 erfaßt. Da der Abstand dieser Startpunkte in Zeilenrichtung jenem der Kreuzpunkte der aufzubauenden Kreuze K1 und K2 entspricht, kann jeweils schon zu Beginn der Abstand zwischen den Punkten ST1 und ST2 als $\Delta y$ ermittelt werden. Hierzu dient ein Subtrahierglied 43 am Ausgang der Vor-Rück-Zähler 16 und 17. Die vom Subtrahierglied 43 ermittelte Wegdifferenz $\Delta y$ wird über einen Digital-Analog-Wandler 44 sowie einen Entkoppelverstärker 45 auf eine Verrechnungsschaltung 46 gegeben. Der Wegabstand $\Delta x$ in Horizontalrichtung wird nicht direkt als Abstandswert der Punkte ST1 und ST2 ermittelt. Die Wegmessung erfolgt vielmehr direkt zwischen den Mittelpunkten der Kreuze K1 und K2, so daß eventuelle Verzerrungen bei ungleichem Zeilenabstand vermieden werden. Wird jedoch von vornherein Äquidistanz der Zeilen gewährleistet, so kann $\Delta x$ selbstverständlich ebenso wie $\Delta y$ zwischen ST1 und ST2 ermittelt werden. Zur Ermittlung des horizontalen Abstandes $\Delta x$ dienen spezielle Zähler innerhalb der Steuerlogik 30 zur Markeneinblendung. Von diesen Zählern werden im Augenblick des Kreuzmittelpunktes der Kreuze K1 und K2 Sample and Hold-Schaltungen 47 bzw. 48 angestoßen, die daraufhin am Eingang BK den aktuellen Wert der Bildkippspannung abtasten und festhalten. Dieser aktuelle Wert entspricht jedoch unmittelbar der x-Koordinate des jeweiligen Kreuzmittelpunktes. Am Ausgang der Sample and Hold-Schaltungen wird dann die Differenz $\Delta x$ in einem Subtrahierglied 49 gebildet. Die Ausgangsgröße $\Delta x$ kann dann der Verrechnungsschaltung 46 zur Berechnung des Abstandes

$$\sqrt{\Delta x^2 + \Delta y^2}$$

zugeleitet werden. Der so ermittelte Abstandswert kann nach Analog-Digital-Wandlung im Analog-Digital-Wandler 50 auf eine Steuerlogik 51 zur Einblendung als Anzeigewert in das Bild der Bildröhre 32 über die Steuerlogik 30 gegeben werden. Anstelle des Differenzbildners 49 und der Rechenschaltung 46 können auch Integratoren eingesetzt werden, die im Bereich zwischen den Abtastwerten der Bildkippspannung BK letztere integrieren, so daß man direkt $\Delta y^2$ erhält. Wird in entsprechender Weise auch mit $\Delta x$ unter Zuhilfenahme der Zeilenkippspannung ZK verfahren, so erhält man $\Delta x^2 + \Delta y^2$

durch einfache Integration und nachfolgender Addition. Durch Wurzelbildung oder Einsatz eines quadratisch geeichten Anzeigegerätes erhält man dann wiederum in einfachster Weise und mit sehr guter Genauigkeit den gesuchten Abstand.

Die Erzeugung der Meßkreuze K1 und K2 in Abhängigkeit von den anfallenden Komparatorsignalen wird anhand der Fig. 2 verdeutlicht, die den inneren Aufbau der Steuerlogik 30 für die Markeneinblendung detaillierter wiedergibt. Gemäß der Darstellung der Fig. 2 werden die in den Startpunkten ST1 und ST2 anfallenden Komparatorsignale der Komparatoren 24, 25, 26 und 27 auf Zähler 52, 53, 54 und 55 gegeben. Die beiden Zähler 52 und 53 sind Vertikalzähler für die Helltastpunkte in der Vertikalen eines Kreuzes. Die Zähler 54 und 55 sind entsprechend Horizontalzähler für die Helltastpunkte im Horizontalbalken des Kreuzes. Jeder der beiden Zähler 52 und 53 zählt demnach entsprechend der Zahl maximaler Helltastpunkte entlang einer Zeile an einem ersten Aus- gang von eins bis neun. Mit jedem Zähltakt wird ein Ausgangsimpuls erzeugt und dem einen Eingang eines UND-Gliedes 56 zugeleitet. Jeder fünfte Zählimpuls wird ferner über einen zweiten Ausgang des Zählers 52 auf ein weiteres UND-Glied 57 gegeben. Beide UND-Glieder 56 und 57 sind mit ihrem jeweils anderen Eingang mit Ausgängen des Horizontalzählers 54 verbunden. Der Horizontalzähler 54 zählt an einem ersten Ausgang(1...7) jeweils von eins bis sieben und führt die Ausgangsimpulse dieses Ausganges dem UND-Glied 57 zu. Jeder vierte Impuls wird über den zweiten Ausgang (4) auf das UND-Glied 56 gegeben. Beide UND-Glieder 56 und 57 sind ausgangsseitig über ein ODER-Glied 58 mit dem Ausgangs-ODER-Glied 59 für Helltastimpulse HT der Steuerlogik 30 verbunden. Aufgrund dieser speziellen Zusammenschaltungsart eines Vertikal- und eines Horizontalzählers ergibt sich ein Taktschema, bei dem erstmals nach Startbeginn ST1 jeweils nach jedem fünften Taktschritt pro Zeile am Ausgang (5) des Vertikalzählers 52 und am Ausgang (1...7) des Horizontalzählers 54 gleichzeitig Ausgangsimpulse anfallen. Der Elektronenstrahl der Bildröhre wird im Takt der sieben Ausgangsimpulse des Zählers 54 hellgetastet und es ergeben sich die sieben Hellpunkte des waagrechten Kreuzbalkens. Von die sieben Punkten stellt der jeweils vierte als Mittelpunkt des Kreuzes einen Sonderfall dar. Hier erscheinen nämlich gleichzeitig mit dem Impuls am Ausgang (4) des Horizontalzählers 54 im Fortlauf der Zeilenablenkung insgesamt neun Ausgangsimpulse am Ausgang (1...9) des Vertikalzählers 52. Über das UND-Glied 56 und die ODER-Glieder 58 bis 59 erscheinen insgesamt neun Helltastimpulse zur Abbildung des Vertikalbalkens des Kreuzes K1 in neun Hellpunkten.

Die beschriebene Funktionsweise gilt im Prinzip auch für das Kreuz K2, das mittels Vertikalzähler 53 und Horizontalzähler 55 über die UND-Glieder 60 und 61 sowie über das mit dem Ausgangs-ODER-Glied 59 verbundene ODER-Glied 62 festgelegt wird.

Die beschriebene Steuerlogik 30 zur Markeneinblendung sorgt also dafür, daß hinsichtlich eines darzustellenden Kreuzes K1 oder K2 die zugehörigen Hellpunkte jedes Kreuzbalkens ohne Informationsverlust genau auf den jeweils zugeordneten Bildzeilen liegend im Ultraschall-Echo-Sichtbild auf dem Bildschirm der Bildröhre 32 darstellbar sind. Darüber hinaus gewährleistet die spezielle Beschaltung mit Vertikal- und Horizontalzählern auch die Möglichkeit der Abstandsmessung zwischen den Kreuzpunkten der beiden dargestellten Meßkreuze K1 und K2. Der Kreuzpunkt eines Kreuzes K1 oder K2 ist zeitlich gesehen definiert durch das Zusammentreffen zweier Zählimpulse, nämlich des vierten Impulses am Ausgang (4) eines Horizontalzählers 54 bzw. 55 und dem jeweils fünften Zählimpuls am Ausgang (5) eines Vertikalzählers 52 bzw. 53.

In der Schaltung der Fig. 2 sind demnach diese betreffenden Ausgänge eines jeden Zählerpaares 52, 54 bzw. 53, 55 über ein weiteres UND-Glied 63 bzw. 64 miteinander verknüpft. An den Ausgängen dieser UND-Glieder 63 bzw. 64 wird ein Impuls immer dann erzeugt, wenn also sich der Elektronenstrahl im Mittelpunkt eines Meßkreuzes K1 bzw. K2 zur Helltastung befindet. Die Mitteilung des Ausgangsimpulses eines UND-Gliedes 63 bzw. 64 an die nachgeschaltete Sample-and-Hold-Schaltung 47 bzw. 48 bewirkt die Abtastung des Momentanwertes der Bildkippspannung BK in den Kreuzpunkten zur Differenzbildung zwecks Ermittlung der Wegstrecke $\Delta$ x.

Patentansprüche

1. Mechanisch/elektrische Steuervorrichtung zum Verschieben eines Gegenstandes, insbesondere Markierungen auf dem Bildschirm einer Bildröhre, in eine erwünschte Position, mit wenigstens einem von Hand aus einer Ruhelage auslenkbaren Proportionalgeber, der Auslenksignale entsprechend der Auslenkung erzeugt und mit einem Positionssignalgeber, der gesteuert von den Auslenksignalen des Proportionalgebers Positionssignale zur Verschiebung des Gegenstandes erzeugt, d a d u r c h  g e - k e n n z e i c h n e t , daß zwischen Proportionalgeber (1 bis 7) und Positionssignalgeber (24 bis 31) eine Festhaltevorrichtung (16 bis 23) zum Festhalten jeweils jenes Auslenksignales einer Auslenkung des Proportionalgebers (1 bis 7) vorhanden ist, das im Umkehrpunkt der Auslenkung vor Rückführung des Proportionalgebers in die Ruhelage anfällt.

2. Steuervorrichtung nach Anspruch 1, d a d u r c h g e k e n n z e i c h n e t,  daß die Festhaltevorrichtung für jede Auslenkkoordinate einen Signalspeicher (16 bis 19) umfaßt, der bei einer Auslenkung des Proportionalgebers (1 bis 7) aus der Ruhelage in Auslenkrichtung der Koordinate ständig mit den dabei anfallenden Auslenksignalen beaufschlagt wird und der erst unmittelbar nach Durchlaufen des Umkehrpunktes der Auslenkung von weiterer Beaufschlagung mit Auslenksignalen des Rücklaufes in die Ruhelage des Proportionalgebers abgetrennt wird, so daß lediglich noch der Ablenksignalwert im Umkehrpunkt der Ablenkung gespeichert ist.

3. Steuervorrichtung nach Anspruch 2, d a d u r c h g e k e n n z e i c h n e t , daß vom Signalspeicher (16 bis 19) ein nach Abtrennung gespeicherter Ablenksignalwert erst dann wieder geändert wird, wenn aus der wieder eingenommenen Ruhelage heraus der Proportionalgeber (1 bis 7) unter Wiederankopplung des Signalspeichers erneut ausgelenkt wird.

4. Steuervorrichtung nach einem der Ansprüche 1 bis 3, d a d u r c h  g e k e n n z e i c h n e t , daß die Festhaltevorrichtung Teil eines zwischen Proportionalgeber (1 bis 7) und Positionssignalgeber (24 bis 31) eingeschalteten Auslenkweg/Verschiebungsgeschwindigkeit-Umsetzers (8 bis 11) ist, der ein mit zunehmendem Auslenkweg des Proportionalgebers sich entsprechend rascher änderndes Auslenksignal zur entsprechend rascheren Aktivierung des Positionssignalgebers (24 bis 31) im Sinne der schnelleren Verschiebung des Gegenstandes erzeugt.

5. Steuervorrichtung nach Anspruch 4, d a d u r c h  g e k e n n z e i c h n e t , daß ein sich proportional zum Auslenkweg des Proportionalgebers (1 bis 7) änderndes Ausgangssignal auf einen Impulsgenerator (12 bis 15) gegeben wird, der mit steigender Eingangsamplitude zu höheren Impulsfolgefrequenzen gesteuert wird und dessen Ausgangsimpulse in einen Impulszähler (16 bis 19) eingezählt werden, der das Speicherglied für die Speicherung des Ablenksignalwertes im Umkehrpunkt einer Ablenkung ist.

6. Steuervorrichtung nach Anspruch 5, d a d u r c h  g e k e n n z e i c h n e t , daß der Pulsgenerator bei einem Eingangssignal, das vom Proportionalgeber bei Einnahme der Ruhelage anfällt, von der Erzeugung weiterer Impulse abgeschaltet ist und daß das Speicherglied (16 bis 19) ein Vorwärts/Rückwärtszähler ist, der gesteuert von einem Richtungssignalgeber (20 bis 23) vorwärts zählt, wenn am Richtungssignalgeber ein Vorwärtszählsignal anfällt und der nur rückwärts zählt, wenn am Richtungssignalgeber ein Rückwärtszählsignal anfällt, wobei der Richtungssignalgeber in Abhängigkeit von dem Ausgangssignal des Proportionalgebers sein Vorwärtszählsignal nur dann erzeugt, wenn der Proportionalgeber aus der Ruhelage in eine erste Auslenkrichtung ausgelenkt wird und der ein Rückwärtszählsignal nur dann erzeugt, wenn der Proportionalgeber nach Durchqueren der Ruhelage in die entgegengesetzte zweite Richtung ausgelenkt wird.

7. Steuervorrichtung nach einem der Ansprüche 1 bis 5, d a d u r c h   g e k e n n z e i c h n e t , daß die Festhaltevorrichtung (16 bis 23) ausgangsseitig mit einem ersten Eingang von Komparatoren (24 bis 27) verbunden ist, die als Bestandteil des Positionssignalgebers Steuersignale für eine Helltastimpulserzeugungseinrichtung (30, 33) erzeugen, wenn die in der Festhaltevorrichtung gespeicherten Werte jenen entsprechen, die als Zeilenpositionssignal oder Bildpositionssignal dem zweiten Komparatoreingang zugeleitet werden.

8. Steuervorrichtung nach Anspruch 7, d a d u r c h   g e k e n n z e i c h n e t , daß die Zeilenpositionssignale durch einen dritten Zähler (28) innerhalb des Positionsgebers gewonnen werden, der im Takt (ZK) einer jeden Zeilenaufzeichnung an einem bildanzeigenden System (32) zur Zählung von Zählimpulsen eines weiteren Impulsgenerators (29) aktiviert wird, welche Zählimpulse im Fortschritt des Zeilenlaufes während Zeilenablenkung die jeweils darzustellende Zeile in eine vorgebbare Anzahl von Zeilensegmenten zerlegen.

9. Steuervorrichtung nach Anspruch 7 oder 8, d a - d u r c h   g e k e n n z e i c h n e t , daß das

- 4 -    VPA 79 P 5016   EUR

Bildpositionssignal durch Vergleich der Ausgangswerte der Festhaltevorrichtung für Auslenkung in Richtung der Zeilenverschiebung mit dem Zählerstand eines Zeilenzählers (31) in den Komparatoren (26, 27) gewonnen wird.

10. Steuervorrichtung nach einem der Ansprüche 1 bis 9, d a d u r c h   g e k e n n z e i c h n e t , daß sie zum Positionieren von Meßkreuzen (K1, K2) im Sichtbild einer Bildröhre, vorzugsweise im Ultraschall-Echo-Sichtbild der Bildröhres eines Ultraschall-Schnittbildgerätes, dient.

FIG 1

FIG 2

FIG 3